# EUROPÄISCHE PATENTSCHRIFT

(11) **EP 2 355 356 B1**
(45) Veröffentlichungstag und Bekanntmachung des Hinweises auf die Patenterteilung: **23.11.2016**
(21) Anmeldenummer: 11000756.4
(22) Anmeldetag: 01.02.2011
(51) Int. Cl.: H03K 17/96

(54) **Kapazitiver Berührungs- und/oder Annäherungsschalter**
Capacitative touch and/or proximity sensor
Commutateur de contact et/ou de rapprochement capacitif

(30) Priorität: 04.02.2010 DE 102010006777
(43) Veröffentlichungstag der Anmeldung: 10.08.2011
(73) Patentinhaber: Diehl AKO Stiftung & Co. KG, 88239 Wangen im Allgäu (DE)
(72) Erfinder: Siebachmeyer, Fritz, 88099 Neukirch (DE)
(74) Vertreter: Diehl Patentabteilung

(56) Entgegenhaltungen:
- WO-A1-2009/153161
- US-A- 5 917 165
- ANONYMOUS: 'PEDOT:PSS - Wikipedia, the free encyclopedia', [Online] 17 Dezember 2009, XP055281618 Gefunden im Internet: <URL:https://en.wikipedia.org/w/index.php?t itle=PEDOT:PSS&oldid=332268878> [gefunden am 2016-06-17]

## Beschreibung

Die vorliegende Erfindung betrifft einen kapazitiven Berührungs- und/oder Annäherungsschalter.

In vielen elektrischen bzw. elektronischen Geräten, insbesondere auch in Haushaltsgeräten wie Herden, Kochfeldern, Mikrowellenöfen, Spülmaschinen, Waschmaschinen, Wäschetrocknern und dergleichen, werden häufig berührungsempfindliche Tastschalter bzw. Berührungs- und/oder Annäherungsschalter eingesetzt, die durch ein einfaches Berühren oder Annähern durch einen Benutzer bzw. einen Finger des Benutzers zum Beispiel einen bestimmten Schaltvorgang auslösen und/oder eine Geräteeinstellung ändern.

Im Fall eines kapazitiven Berührungs- und/oder Annäherungsschalters bildet ein kapazitives Sensorelement zusammen mit zum Beispiel einem Finger eines Benutzers über eine als Dielektrikum wirkende Abdeckung eine Kapazität, die entsprechend dem Betätigen des Tastschalters, d.h. dem Berühren oder Nicht-Berühren eines dem kapazitiven Sensorelement zugeordneten Berührungsfeldes der Abdeckung variabel ist. Die Veränderung des Kapazitätswertes des kapazitiven Sensorelements wirkt sich entsprechend auf ein Ausgangssignal der Sensorschaltung aus, was von einer Auswerteelektronik ggf. als eine Betätigung des kapazitiven Berührungs- und/oder Annäherungsschalters interpretiert werden kann. Insbesondere entsteht beim Berühren des Berührungsfeldes durch einen Benutzer zur Kopplungsfläche des Sensorelements eine Kopplungskapazität, über die von der Sensorschaltung ein Ableitstrom zum Benutzer fließt, der von der Auswerteelektronik erkannt wird.

Als Sensorelement eines solchen kapazitiven Berührungs- und/oder Annäherungsschalters kann zum Beispiel eine Druckfeder aus einem elektrisch leitenden Material, die mit elektrisch leitenden Kontaktflächen zur Abdeckplatte und zu einer Kontaktfläche auf einer Leiterplatte versehen ist, eingesetzt werden, wie dies zum Beispiel in der DE 10 2005 053 792 A1 beschrieben ist.

Die US 5,917,165 A beschreibt einen kapazitiven Berührungsschalter, dessen Sensorelement durch einen Körper aus einem weichelastischen Kunststoff oder Gummi, versehen mit elektrisch leitfähigen Füllkörpern, besteht. In einer Variante dieses herkömmlichen Berührungsschalters ist dieser Körper mit einer Durchgangsöffnung ausgebildet, in welcher eine Leuchtdiode angeordnet ist, um das Berührungsfeld der Abdeckplatte zu beleuchten.

Ferner ist aus der DE 10 2004 060 846 B4 ein kapazitiver Berührungs- und/oder Annäherungsschalter bekannt, bei dem das Sensorelement aus einem elastischen bzw. flexiblen Körper aus einem elektrisch isolierenden Material gebildet ist, welcher zur Erzielung der erforderlichen elektrischen Eigenschaften des Sensorelements von einem Netz aus einem leitfähigen Material umspannt ist. In einer Variante dieses herkömmlichen Berührungs- und/oder Annäherungsschalters ist der flexible Körper des Sensorelements mit einer Durchgangsöffnung versehen, in welche ein Lichtleitelement eingeführt werden kann, um eine Beleuchtung des Berührungsfeldes zu ermöglichen.

Um eine flächige Hinterleuchtung des Berührungsfeldes der Abdeckplatte zu erzielen, sind aus dem Stand der Technik verschiedene weitere Konstruktionen bekannt.

So zeigt zum Beispiel die EP 1 257 057 A1 einen kapazitiven Berührungsschalter mit einer elektrisch leitenden Sensorfläche an der Rückseite der Abdeckplatte, hinter der eine mit einer Leuchtdiode gekoppelte Lichtleiteinrichtung angeordnet ist. Die Sensorfläche weist zum Beispiel symbolhafte Aussparungen auf, die mittels der Lichtleiteinrichtung hinterleuchtet werden können, und ist über ein an der Lichtleiteinrichtung seitlich vorbei geführtes Kontaktelement elektrisch leitend mit der Auswerteelektronik verbunden.

Ferner besteht auch die Möglichkeit, ein Lichtleitelement aus einem elektrisch isolierenden Material mit einer elektrisch leitenden Beschichtung zum Ausbilden der kapazitiven Kopplungsfläche zu versehen. Diese Beschichtung ist entweder mit lichtdurchlässigen Aussparungen versehen oder teilweise lichtdurchlässig ausgebildet, wie in der US 2009/0115645 A1 bzw. der DE 103 26 684 A1 offenbart. Ein vergleichbares Sensorelement, das eine flexible Folie mit einer transparenten metallischen Beschichtung aufweist ist aus der WO 2009/153161 bekannt.

Es ist die Aufgabe der vorliegenden Erfindung, einen verbesserten kapazitiven Berührungs- und/oder Annäherungsschalter zu schaffen, der einen einfachen Aufbau besitzt und eine Hinterleuchtung des Berührungsfeldes der Abdeckplatte ermöglicht.

Diese Aufgabe wird gelöst durch einen kapazitiven Berührungs- und/oder Annäherungsschalter mit den Merkmalen des Anspruchs 1. Vorteilhafte Weiterbildungen und Ausgestaltungen der Erfindung sind Gegenstand der abhängigen Ansprüche.

Der kapazitive Berührungs- und/oder Annäherungsschalter umfasst eine Abdeckplatte, die auf einer dem Benutzer zugewandten Seite ein Berührungsfeld definiert und zumindest im Bereich des Berührungsfeldes elektrisch isolierend und wenigstens teilweise lichtdurchlässig ausgebildet ist; eine Trägerplatte, die auf einer dem Benutzer abgewandten Seite der Abdeckplatte mit einem Abstand zu dieser angeordnet ist; und ein Kopplungselement, das zwischen der Abdeckplatte und der Trägerplatte dem Berührungsfeld korrespondierend angeordnet ist und das mit einer elektrisch leitenden Kontaktfläche auf der Trägerplatte in Kontakt steht. Gemäß der vorliegenden Erfindung weist das Kopplungselement einen massiven Kunststoffkörper aus einem elektrisch leitfähigen und lichtdurchlässigen Material auf. Außerdem ist wenigstens eine Lichtquelle zum Einkoppeln von Lichtstrahlen in diesen Kunststoffkörper des Kopplungselements vorgesehen.

Der erfindungsgemäße kapazitive Berührungs- und/oder Annäherungsschalter weist ein Kopplungselement mit einem massiven Kunststoffkörper aus einem elektrisch leitfähigen und lichtdurchlässigen Material auf. Dieser Kunststoffkörper dient einerseits als kapazitives Sensorelement, indem er eine elektrisch leitende Kopplungsfläche bereitstellt, die mit einem Benutzer über die als Dielektrikum wirkende Abdeckplatte eine Kapazität bilden kann, und andererseits als Lichtleitelement zur Hinterleuchtung des Berührungsfeldes der Abdeckplatte. Mit anderen Worten stellt der Kunststoffkörper sowohl die kapazitive Sensorfläche als auch die Leuchtfläche für das Berührungsfeld bereit. Dank dieser doppelten Funktionalität des Kunststoffkörpers des Kopplungselements wird ein kapazitiver Berührungs- und/oder Annäherungsschalter mit der Möglichkeit der Hinterleuchtung des Berührungsfeldes mit einer geringen Anzahl an Bauteilen zur Verfügung gestellt. Hierdurch können der Montageaufwand und die Herstellungskosten gesenkt werden.

Elektrisch leitfähige Kunststoffe sind in der Technik seit einiger Zeit bekannt. Diese werden zum Beispiel durch Einbringen von Füllstoffen mit elektrischer Leitfähigkeit in das elektrisch isolierende Kunststoffmaterial hergestellt. Bisher waren allerdings nur lichtundurchlässige oder allenfalls in Folienstärke transparente, elektrisch leitfähige Kunststoffe bekannt. Bei lichtdurchlässigen Kunststoffen führt das Einbringen von Füllstoffen zwangsweise zu einer Eintrübung des Materials, bis hin zur Lichtundurchlässigkeit. Beim Einsatz eines derart modifizierten lichtdurchlässigen Kunststoffmaterials für ein Kopplungselement bei einem kapazitiven Berührungs- und/oder Annäherungsschalter ist jedoch das Einbringen der Füllstoffe in das Material auch optisch von Vorteil, da dies aufgrund der Streuwirkung zu einer gleichmäßig ausgeleuchteten Kopplungsfläche des Kunststoffkörpers zum Zwecke der Hinterleuchtung des Berührungsfeldes führt. Je nach ausgewähltem Kunststoffmaterial und Füllkörper kann daher problemlos ein funktionsfähiger Kompromiss zwischen der elektrischen Leitfähigkeit und der optischen Transparenz gefunden werden.

Das Versehen des lichtdurchlässigen Kunststoffmaterials mit einer elektrischen Leitfähigkeit ist jedoch nicht nur auf das Einbringen von Füllkörpern beschränkt.

Es sind hierzu grundsätzlich beliebige Fertigungsverfahren denkbar, beispielsweise auch das Modifizieren der molekularen Struktur des Kunststoffmaterials, der Einsatz von Nanotechnologie und dergleichen.

Im Rahmen der vorliegenden Erfindung kann die "Trägerplatte" zum Beispiel eine Leiterplatte oder eine einfache Kunststoffplatte sein. Die Trägerplatte kann außerdem als stabiler Plattenkörper ausgebildet sein oder nur Folienstärke besitzen.

Auf der "Trägerplatte" ist im Allgemeinen auch die "Auswerteelektronik" zum Verarbeiten und Auswerten der von der Sensorschaltung erzeugten Ausgangssignale, um ein Betätigen des Schalters durch ein Berühren/Annähern bzw. Nicht-Berühren/Annähern festzustellen, vorgesehen. Von dieser Auswerteelektronik zu unterscheiden ist die Steuerung z.B. des Haushaltsgerätes, mit welcher die Auswerteelektronik verbunden ist und welche wahlweise ebenfalls auf der Trägerplatte oder an einer anderen Stelle im Haushaltsgerät angeordnet sein kann. In einigen Anwendungen kann die Auswerteelektronik auch in diese Steuerung integriert sein.

Das Kopplungselement ist "dem Berührungsfeld korrespondierend" angeordnet. Im Rahmen dieser Erfindung bedeutet dies, dass die Dimensionierung, die Form und die Platzierung des Kopplungselements bzw. dessen Kunststoffkörpers hinter der Abdeckplatte die Dimensionierung, die Form bzw. die Position des Berührungsfeldes auf der Abdeckplatte bestimmen. Das Berührungsfeld kann für den Benutzer auf der Abdeckplatte zusätzlich optisch und/oder haptisch gekennzeichnet sein, um die Bedienung durch den Benutzer zu vereinfachen.

Die Abdeckplatte soll "im Bereich des Berührungsfeldes elektrisch isolierend und wenigstens teilweise durchlässig" ausgebildet sein. Dies bedeutet in Zusammenhang mit der vorliegenden Erfindung, dass die Abdeckplatte zumindest im Bereich des Berührungsfeldes elektrisch isolierend ausgebildet ist, sodass sie in diesem Bereich als ein Dielektrikum für das kapazitive Sensorelement dienen kann. Andere Bereiche der Abdeckplatte können wahlweise elektrisch isolierend oder durchaus elektrisch leitfähig ausgebildet sein. Außerdem muss das Berührungsfeld nicht vollständig lichtdurchlässig ausgestaltet sein. Durch das Vorsehen lichtdurchlässiger und lichtundurchlässiger Abschnitte können zum Beispiel Symbole oder dergleichen dargestellt werden, die mittels der wenigstens einen Lichtquelle des Schalters hinterleuchtet werden können.

In einer Ausgestaltung der Erfindung weist der Kunststoffkörper des Kopplungselements eine erste Kopplungsfläche auf, welche die dem Benutzer abgewandte Seite der Abdeckplatte im Bereich des Berührungsfeldes kontaktiert. Hierdurch kann ein minimaler und gleichmäßiger Abstand zur Abdeckplatte gewährleistet werden, was zu einer Erhöhung der Empfindlichkeit des Berührungs- und/oder Annäherungsschalters führen kann. Alternativ ist es aber auch möglich, den Kunststoffkörper des Kopplungselements mit Abstand zur Abdeckplatte anzuordnen.

Ferner kann der Kunststoffkörper des Kopplungselements eine zweite Kopplungsfläche aufweisen, welche die Kontaktfläche der Trägerplatte entweder direkt oder mittelbar über ein elektrisch leitendes Kontaktelement elektrisch leitend kontaktiert.

In einer Ausführungsform ist der Kunststoffkörper des Kopplungselements in einem Abstand zur Trägerplatte angeordnet und das Kontaktelement ist in diesem Fall ein zwischen dem Kunststoffkörper des Kopplungselements und der Trägerplatte angeordnetes Abstandselement zur Überbrückung dieses Abstandes und Herstellung der elektrisch leitenden Verbindung zwischen dem elektrisch leitenden Kunststoffkörper und der Kontaktfläche der Trägerplätte. In einer anderen Ausführungsform ist das Kontaktelement ein zwischen dem Kunststoffkörper des Kopplungselements und der Trägerplatte angeordnetes elastisches Element (z.B. eine Feder), das den Kunststoffkörper in Richtung zur Abdeckplatte drückt.

Anstelle einer elektrisch leitenden Verbindung zwischen dem elektrisch leitenden Kunststoffkörper und der Kontaktfläche der Trägerplatte kann auch vorgesehen sein, dass der Kunststoffkörper des Kopplungselements eine zweite Kopplungsfläche aufweist, welche mit der Kontaktfläche der Trägerplatte kapazitiv gekoppelt ist, d.h. zu dieser einen Abstand aufweist.

In einer weiteren Ausgestaltung der Erfindung ist der Kunststoffkörper des Kopplungselements aus einem elastischen Material gemacht. Auf diese Weise können zum Beispiel Bauteiltoleranzen zwischen dem Kunststoffkörper des Kopplungselements und der Abdeckplatte und/oder zwischen dem Kunststoffkörper des Kopplungselements und der Kontaktfläche der Trägerplatte bzw. zwischen dem Kunststoffkörper und dem Kontaktelement des Kopplungselements ausgeglichen werden und auf diese Weise ein funktionssicherer Berührungs- und/oder Annäherungsschalter geschaffen werden.

Des Weiteren kann die wenigstens eine Lichtquelle auf und/oder in der Trägerplatte montiert sein. Außerdem kann die wenigstens eine Lichtquelle auf der der Trägerplatte zugewandten Seite des Kunststoffkörpers des Kopplungselements und/oder seitlich neben dem Kunststoffkörpers des Kopplungselements angeordnet sein.

In einer weiteren Ausgestaltung der Erfindung ist das Kopplungselement an der Abdeckplatte und/oder an der Trägerplatte befestigt. Dies kann zum Beispiel über eine Klebe-, eine Löt- oder eine Rastverbindung erfolgen. Außerdem kann diese Befestigung wahlweise dauerhaft oder lösbar ausgeführt sein.

Mittels einer derartigen Befestigung des Kopplungselements an Abdeckplatte und Trägerplatte kann zudem eine Befestigung der Trägerplatte hinter der Abdeckplatte erreicht werden.

In einer noch weiteren Ausgestaltung der Erfindung ist die Kontaktfläche der Trägerplatte relativ zum Berührungsfeld der Abdeckplatte versetzt angeordnet und ist das Kopplungselement (d.h. dessen Kunststoffkörper und/oder dessen Kontaktelement) derart ausgestaltet, dass es diesen Versatz überbrückt. Bei dieser Konstruktion kann eine größere Freiheit bei der Anordnung der Berührungsfelder auf der Abdeckplatte bzw. der Kontaktflächen auf der Trägerplatte erzielt werden, da diese nicht genau einander korrespondierend gegenüber liegend angeordnet sein müssen.

Der oben beschriebene kapazitive Berührungs- und/oder Annäherungsschalter gemäß der Erfindung ist in vorteilhafter Weise in Bedienblenden von elektrischen bzw. elektronischen Haushaltsgeräten einsetzbar.

Obige sowie weitere Merkmale und Vorteile der Erfindung werden aus der nachfolgenden Beschreibung bevorzugter, nicht-einschränkender Ausführungsbeispiele unter Bezug auf die beiliegenden Zeichnungen besser verständlich. Darin zeigen:
- Fig. 1: eine schematische Schnittansicht eines kapazitiven Berührungs- und/oder Annäherungsschalters gemäß einem ersten Ausführungs-beispiel der vorliegenden Erfindung;
- Fig. 2: eine schematische Schnittansicht eines kapazitiven Berührungs- und/oder Annäherungsschalters gemäß einem zweiten Ausführungsbeispiel der vorliegenden Erfindung;
- Fig. 3: eine schematische Schnittansicht eines kapazitiven Berührungs- und/oder Annäherungsschalters gemäß einem dritten Ausführungsbeispiel der vorliegenden Erfindung;
- Fig. 4: eine schematische Schnittansicht eines kapazitiven Berührungs- und/oder Annäherungsschalters gemäß einem vierten Ausführungsbeispiel der vorliegenden Erfindung;
- Fig. 5: eine schematische Schnittansicht eines kapazitiven Berührungs- und/oder Annäherungsschalters gemäß einem fünften Ausführungsbeispiel der vorliegenden Erfindung;
- Fig. 6: eine schematische Schnittansicht eines kapazitiven Berührungs- und/oder Annäherungsschalters gemäß einem sechsten Ausführungsbeispiel der vorliegenden Erfindung;
- Fig. 7: eine schematische Schnittansicht eines kapazitiven Berührungs- und/oder Annäherungsschalters gemäß einem siebten Ausführungsbeispiel der vorliegenden Erfindung;
- Fig. 8: eine schematische Schnittansicht eines kapazitiven Berührungs- und/oder Annäherungsschalters gemäß einem achten Ausführungsbeispiel der vorliegenden Erfindung; und
- Fig. 9: eine schematische Schnittansicht eines kapazitiven Berührungs- und/oder Annäherungsschalters gemäß einem neunten Ausführungsbeispiel der vorliegenden Erfindung.

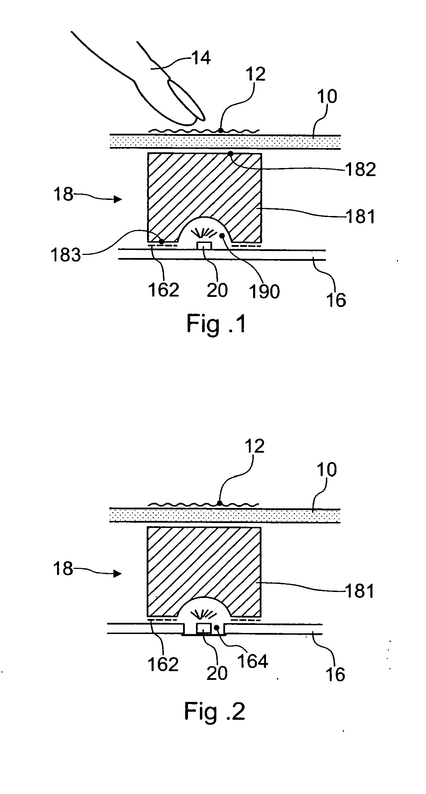

In den Figuren 1 bis 9 sind verschiedene Ausführungsformen eines kapazitiven Berührungs- und/oder Annäherungsschalters gemäß der vorliegenden Erfindung beispielhaft dargestellt. Dabei sind gleiche bzw. entsprechende Komponenten jeweils mit den gleichen Bezugsziffern gekennzeichnet. Auf eine wiederholte Beschreibung von Aufbau und Funktionsweise der einzelnen Komponenten bei allen Ausführungsbeispielen wird der Einfachheit halber verzichtet.

Es sei darauf hingewiesen, dass die in den Figuren 1 bis 9 gezeigten Merkmale des Berührungs- und/oder Annäherungsschalters zudem in vielfältiger Weise miteinander kombiniert werden können, ohne dass nachfolgend alle möglichen Ausführungsformen bzw. Merkmalskombination im Detail genannt werden.

Bezug nehmend auf Figur 1 wird nun ein kapazitiver Berührungs- und/oder Annäherungsschalter eines ersten Ausführungsbeispiels erläutert.

Der kapazitive Berührungs- und/oder Annäherungsschalter umfasst insbesondere ein hinter einer Abdeckplatte 10 angeordnetes Kopplungselement 18, das im Wesentlichen aus einem elektrisch leitfähigen und lichtdurchlässigen Kunststoffkörper 181 besteht. Dieser Kunststoffkörper 181 hat auf seiner der Abdeckplatte 10 zugewandten Seite eine erste Kopplungsfläche 182. Form, Größe und Position dieser ersten Kopplungsfläche 182 des Kunststoffkörpers 181 des Kopplungselements 18 definieren ein Berührungsfeld 12 auf der Abdeckplatte 10, welches von einem Benutzer mit seinem/ihrem Finger 14 berührt werden kann, um den Berührungs- und/oder Annäherungsschalter zu betätigen.

Die Abdeckplatte 10 ist zumindest im Bereich des Berührungsfeldes 12 elektrisch isolierend ausgebildet. Sie ist zum Beispiel aus einem elektrisch isolierenden Material wie Glas, Glaskeramik oder Kunststoff gefertigt. Diese elektrisch isolierende Abdeckplatte 10 dient als ein Dielektrikum des durch den Finger 14 des Benutzers und den elektrisch leitfähigen Kunststoffkörper 181 des Kopplungselements gebildeten Kondensators, dessen Kapazitätsänderungen in bekannter Weise erfasst werden.

Außerdem ist die Abdeckplatte 10 im Bereich des Berührungsfeldes 12 wenigstens teilweise lichtdurchlässig ausgebildet. Durch lichtdurchlässige Abschnitte und lichtundurchlässige Abschnitte im Bereich des Berührungsfeldes 12 können dabei auch Symbole erzeugt werden, die wie weiter unten erläutert für den Benutzer hinterleuchtet werden können.

Die erste Kopplungsfläche 182 des Kunststoffkörpers 181 des Kopplungselements 18 ist im Wesentlichen parallel zur Abdeckplatte 10 ausgerichtet, sodass der gebildete Kondensator eine gleichmäßige Kapazitätsverteilung besitzt. Dabei kann die erste Kopplungsfläche 182 des Kunststoffkörpers 181 wahlweise mit der dem Benutzer abgewandten Seite der Abdeckplatte 10 vollflächig in Kontakt stehen oder von der Abdeckplatte 10 beabstandet sein. Im Fall einer Kontaktierung der Abdeckplatte 10 kann der Kunststoffkörper 181 außerdem an dieser befestigt, zum Beispiel angeklebt sein.

Auf der der Abdeckplatte 10 abgewandten Seite weist der Kunststoffkörper 181 eine zweite Kopplungsfläche 183 auf. Diese steht mit einer elektrisch leitenden Kontaktfläche 162 einer Trägerplatte 16, die in Abstand hinter der Abdeckplatte 10 angeordnet ist, in Kontakt. Diese Trägerplatte 16 trägt neben der Sensorschaltung auch die Auswerteelektronik (nicht dargestellt). Diese Auswerteelektronik kann Teil der Steuerung (nicht dargestellt) des Haushaltsgerätes sein oder mit dieser über entsprechende Kabelverbindungen verbunden sein.

Die zweite Kopplungsfläche 183 des Kunststoffkörpers 181 des Kopplungselements 18 steht vorzugsweise großflächig mit der Kontaktfläche 162 der Trägerplatte 16 in Kontakt und ist mit dieser fest verbunden, zum Beispiel verlötet oder verklebt.

Wie in Figur 1 dargestellt, ist der Kunststoffkörper 181 des Kopplungselements 18 an seiner der Trägerplatte 16 zugewandten Seite mit einer Aussparung 190 ausgebildet. In dieser Aussparung 190 ist eine Lichtquelle 20 wie beispielsweise eine Leuchtdiode angeordnet. Die Leuchtdiode 20 ist vorzugsweise auf der Trägerplatte 16, insbesondere auf ihrer dem Kopplungselement 18 zugewandten Seite montiert.

Wie bereits erwähnt, ist der Kunststoffkörper 181 des Kopplungselements 18 als ein elektrisch leitfähiger und lichtdurchlässiger Kunststoffkörper ausgebildet. Auf diese Weise dient er einerseits als kapazitives Sensorelement, indem seine erste Kopplungsfläche 182 als Elektrode des Kondensators variabler Kapazität fungiert und der Körper 181 über seine zweite Kopplungsfläche 183 einen elektrisch leitenden Kontakt zur Sensorschaltung bzw. Auswerteelektronik auf der Trägerplatte 16 herstellt. Gleichzeitig dient der Kunststoffkörper 181 als ein Lichtleitelement zum Leiten der von der Lichtquelle 20 ausgesendeten Strahlung zu seiner ersten Kopplungsfläche 182, die als Leuchtfläche dient, um das Berührungsfeld 12 zu hinterleuchten. Durch eine derartige Hinterleuchtung des Berührungsfeldes 12 kann dieses für den Benutzer gekennzeichnet werden oder können dem Benutzer unterschiedliche Schaltzustände des Berührungs- und/ oder Annäherungsschalters angezeigt werden.

Der Kunststoffkörper 181 des Kopplungselements 18 ist beispielsweise aus einem transparenten Kunststoffmaterial gefertigt, in das Füllkörper mit hoher elektrischer Leitfähigkeit eingebracht sind. In einer anderen Ausführungsform ist auch eine Modifizierung der Struktur des Kunststoffmaterials denkbar, um diesem elektrisch leitende Eigenschaften zu verleihen.

Figur 2 zeigt ein zweites Ausführungsbeispiel eines kapazitiven Berührungs- und/oder Annäherungsschalters gemäß der vorliegenden Erfindung.

Dieses Ausführungsbeispiel unterscheidet sich von dem in Figur 1 gezeigten Aufbau darin, dass die Lichtquelle 20 nicht auf der dem Kopplungselement 18 zugewandten Seite der Trägerplatte 16 montiert ist, sondern innerhalb einer Aussparung oder Durchbrechung 164 in der Trägerplatte 16. Auf diese Weise kann auf die Aussparung 190 im Kunststoffkörper 181 verzichtet werden, was dessen Herstellung einfacher macht.

Bei dieser Ausführungsform ist die Trägerplatte 16 vorzugsweise beidseitig mit Leiterbahnen versehen. Diese Ausführungsvariante ist insbesondere dann vorteilhaft, wenn aus fertigungs- oder montagetechnischen Gründen eine Bestückung der Trägerplatte bzw. Leiterplatte 16 auf der der Abdeckplatte 10 abgewandten Unterseite erfolgen muss.

Alternativ kann die Lichtquelle 20 auch auf der dem Kopplungselement 18 abgewandten Seite der Trägerplatte 16 montiert sein und die Strahlung durch die Durchbrechung 164 in den Kunststoffkörper 181 des Kopplungselements 18 einkoppeln.

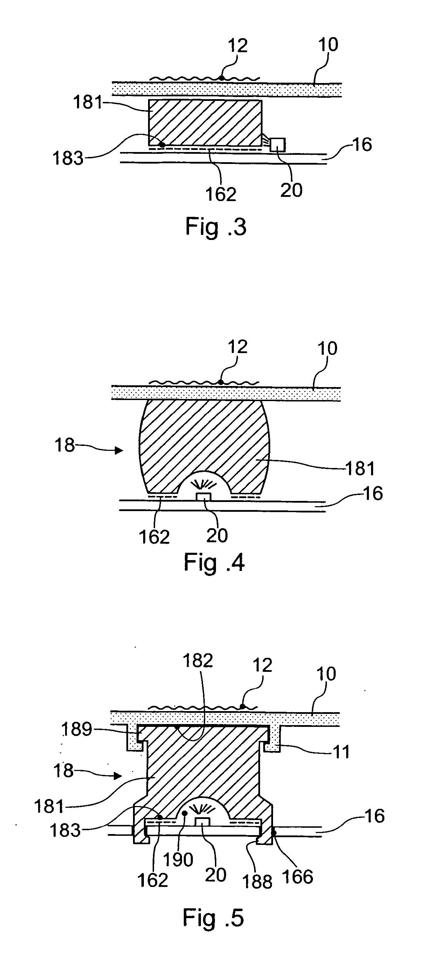

Figur 3 zeigt ein drittes Ausführungsbeispiel eines kapazitiven Berührungs- und/oder Annäherungsschalters gemäß der vorliegenden Erfindung.

Dieses Ausführungsbeispiel unterscheidet sich von dem in Figur 1 gezeigten Aufbau darin, dass die Lichtquelle 20 nicht auf der dem Kopplungselement 18 zugewandten Seite der Trägerplatte 16 montiert ist, sondern seitlich neben dem Kunststoffkörper 181 auf der Trägerplatte 16. Auch auf diese Weise kann auf die Aussparung 190 im Kunststoffkörper 181 verzichtet werden, was dessen Herstellung einfacher macht.

Außerdem ermöglicht die Anordnung der Lichtquelle 20 seitlich neben dem Kunststoffkörper 181 des Kopplungselements 18 eine flache und materialkostengünstige Bauweise des kapazitiven Berührungs- und/oder Annäherungsschalters.

Die anhand der Figuren 1 bis 3 erläuterten Varianten zur Anordnung der wenigstens einen Lichtquelle 20 sind gleichermaßen auch bei den Ausführungsformen der Figuren 4 bis 9 anwendbar.

In Figur 4 ist ein viertes Ausführungsbeispiel eines kapazitiven Berührungs- und/oder Annäherungsschalters gemäß der vorliegenden Erfindung.

Bei diesem Ausführungsbeispiel wird für den Kunststoffkörper 181 des Kopplungselements 18 ein elastisches Kunststoffmaterial (z.B. Silikon) verwendet. Durch die Elastizität des Kunststoffkörpers 181 können sich seine Kopplungsflächen 182, 183 optimal an die Abdeckplatte 10 bzw. die Kontaktfläche 162 der Trägerplatte 16 anpassen.

Auf diese Weise ist es möglich, Fertigungs- und Montagetoleranzen der Komponenten des Berührungs- und/oder Annäherungsschalters auszugleichen. Dies gewährleistet eine hohe Funktionssicherheit des Schalters nach der Herstellung und auch nach längerem Gebrauch.

Ein derartiger elastischer Kunststoffkörper 181 kann auch bei den Ausführungsbeispielen der Figuren 2, 3 und 5 bis 9 benutzt werden.

Ein fünftes Ausführungsbeispiel eines kapazitiven Berührungs- und/oder Annäherungsschalters gemäß der vorliegenden Erfindung ist in Figur 5 dargestellt. Dieses Ausführungsbeispiel veranschaulicht Alternativen zur Befestigung des Kunststoffkörpers 181 des Kopplungselements 18 an der Abdeckplatte 10 bzw. der Trägerplatte 16.

Die Befestigung des Kunststoffkörpers 181 des Kopplungselements 18 erfolgt in diesem fünften Ausführungsbeispiel jeweils über Rast- oder Clips-Verbindungen. Zu diesem Zweck sind an der der Trägerplatte 16 zugewandten Seite des Kunststoffkörpers 181 mehrere (vorzugsweise zwei, drei oder vier) Rastnasen 188 vorgesehen, welche in entsprechend positionierte und dimensionierte Durchbrüche bzw. Rastausnehmungen 166 in der Trägerplatte 16 eingreifen können. Die Rastmechanik 166, 188 ist dabei derart ausgestaltet, dass ein elektrisch leitender Kontakt zwischen der zweiten Kopplungsfläche 183 des Kunststoffkörpers 181 und der Kontaktfläche 162 auf der Trägerplatte 16 gewährleistet ist.

Alternativ ist auch ein kleiner Abstand zwischen dem Kunststoffkörper 181 und der Trägerplatte 16 denkbar, sodass die Kopplung zwischen der zweiten Kopplungsfläche 183 des Kunststoffkörpers 181 und der Kontaktfläche 162 der Trägerplatte 16 kapazitiv ausgeführt ist.

Außerdem sind an der dem Kopplungselement 18 zugewandten Seite der Abdeckplatte 10 ein ringförmiger Rastvorsprung 11 oder mehrere Rastvorsprünge 11 ausgebildet. Diese hintergreifen eine oder mehrere Rastnasen 189, die an dem der Abdeckplatte 10 zugewandten Endbereich des Kunststoffkörpers 181 ausgebildet sind. Auch diese Rastmechanik 11, 189 ist dabei derart gestaltet, dass ein Kontakt zwischen der ersten Kopplungsfläche 181 des Kunststoffkörpers 181 und der Abdeckplatte 10 gewährleistet ist. Alternativ ist auch hier ein kleiner Abstand zwischen dem Kunststoffkörper 181 und der Abdeckplatte 10 denkbar.

Wahlweise ist auch nur eine der beiden Rastverbindungen 11 / 189 oder 166 / 188 vorhanden.

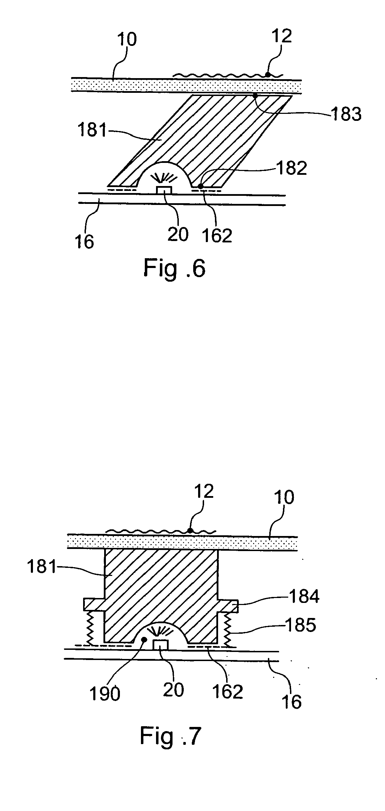

Figur 6 zeigt ein sechstes Ausführungsbeispiel eines kapazitiven Berührungs- und/oder Annäherungsschalters gemäß der vorliegenden Erfindung.

Während in den oben erläuterten Ausführungsbeispielen der Kunststoffkörper 181 des Kopplungselements 18 jeweils im Wesentlichen als ein gerader Zylinder mit beliebigen Grundflächen ausgebildet ist, ist der Kunststoffkörper 181 in dem in Figur 6 veranschaulichten Ausführungsbeispiel im Wesentlichen als ein schräger Zylinder mit beliebigen Grundflächen ausgebildet.

Diese Formgebung des Kunststoffkörpers 181 ermöglicht einen Versatz zwischen dem Berührungsfeld 12 der Abdeckplatte 10 und der Kontaktfläche 161 auf der Trägerplatte 16, die nicht genau übereinander angeordnet sein müssen. Hierdurch entsteht ein größerer Freiheitsgrad bei der Positionierung der Berührungsfelder 12 auf der Abdeckplatte 10 und der Anordnung der Kontaktflächen 162 auf der Trägerplatte 16.

In Figur 7 ist ein siebtes Ausführungsbeispiel eines kapazitiven Berührungs- und/oder Annäherungsschalters gemäß der vorliegenden Erfindung gezeigt.

Wie in Figur 7 dargestellt, ist der Kunststoffkörper 181 des Kopplungselements 18 einem radialen Vorsprung 184 versehen, der wahlweise ringförmig oder abschnittsweise um den Umfang des Kunststoffkörpers 181 herum verläuft. Zwischen der der Trägerplatte 16 zugewandten Seite dieses Vorsprunges 184 und der Trägerplatte 16 sind mehrere elastische Elemente (z.B. Druckfedern) 185 angeordnet.

Die Druckfedern 185 sind aus einem elektrisch leitenden Material (z.B. Metall) gefertigt und stellen den elektrisch leitenden Kontakt zwischen dem elektrisch leitfähigen Kunststoffkörper 181 des Kopplungselements 18 und der Kontaktfläche 162 auf der Trägerplatte 16 her. In einer bevorzugten Variante bilden diese elastischen Elemente 185 mit dem Kunststoffkörper 181 eine Baueinheit. Außerdem drücken sie den Kunststoffkörper 181 mit seiner ersten Kopplungsfläche 182 gegen die Abdeckplatte 10. Auf diese Weise können Fertigungs- und Montagetoleranzen ausgeglichen und Luftspalte zwischen dem Kunststoffkörper 181 und der Abdeckplatte 10 vermieden werden.

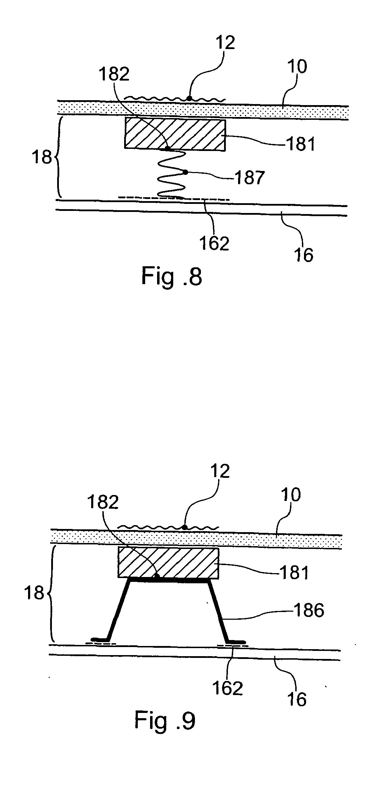

Figur 8 zeigt ein achtes Ausführungsbeispiel eines kapazitiven Berührungs- und/oder Annäherungsschalters gemäß der vorliegenden Erfindung. Die Lichtquelle 20 ist in Figur 8 der Einfachheit halber nicht dargestellt.

In diesem Ausführungsbeispiel umfasst das Kopplungselement 18 zwischen der Abdeckplatte 10 und der Trägerplatte 16 neben dem elektrisch leitfähigen und lichtdurchlässigen Kunststoffkörper 181 noch ein elastisches Abstandelement 187. Der Kunststoffkörper 181 ist mit Abstand zur Trägerplatte 16 angeordnet und das elastische Abstandselement (z.B. Druckfeder) 187 ist zwischen die Trägerplatte 16 und den Kunststoffkörper 181 gesetzt.

Die Druckfeder 187 ist aus einem elektrisch leitenden Material (z.B. Metall) gefertigt und steht einerseits mit der der Trägerplatte 16 zugewandten zweiten Kopplungsfläche 183 des Kunststoffkörpers 181 und andererseits mit der Kontaktfläche 162 auf der Trägerplatte 16 in Kontakt, um eine elektrische Verbindung zwischen dem elektrisch leitfähigen Kunststoffkörper 181 und der Sensorschaltung zu schaffen.

Bei dieser Ausführungsform kann der Kunststoffkörper 181 relativ flach und damit materialkostensparend ausgebildet werden, da er nicht den gesamten Abstand zwischen der Abdeckplatte 10 und der Trägerplatte 16 überbrücken muss. Außerdem drückt die Druckfeder 187 den Kunststoffkörper 181 mit seiner ersten Kopplungsfläche 182 gegen die Abdeckplatte 10, sodass Fertigungs- und Montagetoleranzen ausgeglichen und Luftspalte zwischen dem Kunststoffkörper 181 und der Abdeckplatte 10 vermieden werden können.

Ein neuntes Ausführungsbeispiel eines erfindungsgemäßen kapazitiven Berührungs- und/oder Annäherungsschalters ist in Figur 9 dargestellt. Die Lichtquelle 20 ist in Figur 9 der Einfachheit halber nicht gezeigt.

In diesem Ausführungsbeispiel umfasst das Kopplungselement 18 zwischen der Abdeckplatte 10 und der Trägerplatte 16 neben dem elektrisch leitfähigen und lichtdurchlässigen Kunststoffkörper 181 noch ein im Wesentlichen starres Abstandselement 186. Der Kunststoffkörper 181 ist mit Abstand zur Trägerplatte 16 angeordnet und das zum Beispiel sockelförmige Abstandselement 186 ist zwischen die Trägerplatte 16 und den Kunststoffkörper 181 gesetzt.

Das Abstandselement 186 ist aus einem elektrisch leitenden Material (z.B. Metall) gefertigt und steht einerseits mit der der Trägerplatte 16 zugewandten zweiten Kopplungsfläche 183 des Kunststoffkörpers 181 und andererseits mit der Kontaktfläche 162 auf der Trägerplatte 16 in Kontakt, um eine elektrische Verbindung zwischen dem elektrisch leitfähigen Kunststoffkörper 181 und der Sensorschaltung zu schaffen.

Auch bei dieser Ausführungsform kann der Kunststoffkörper 181 relativ flach und damit materialkostensparend ausgebildet werden, da er nicht den gesamten Abstand zwischen der Abdeckplatte 10 und der Trägerplatte 16 überbrücken muss.

### BEZUGSZIFFERNLISTE

- 10: Abdeckplatte
- 11: Rastvorsprünge
- 12: Berührungsfeld
- 14: Finger
- 16: Trägerplatte
- 162: Kontaktfläche
- 164: Aussparung
- 166: Rastausnehmungen
- 18: Kopplungselement
- 181: Kunststoffkörper
- 182: erste Kopplungsfläche
- 183: zweite Kopplungsfläche
- 184: Vorsprung
- 185: Feder
- 186: Abstandselement, Sockel
- 187: elastisches Element, (Druck-)Feder
- 188: Rastvorsprünge
- 189: Rastnasen
- 190: Aussparung
- 20: Lichtquelle

## Patentansprüche

1. Kapazitiver Berührungs- und/oder Annäherungsschalter, mit einer Abdeckplatte (10), die auf einer dem Benutzer zugewandten Seite ein Berührungsfeld (12) definiert und zumindest im Bereich des Berührungsfeldes (12) elektrisch isolierend und wenigstens teilweise lichtdurchlässig ausgebildet ist;
einer Trägerplatte (16), die auf einer dem Benutzer abgewandten Seite der Abdeckplatte (10) mit einem Abstand zu dieser angeordnet ist;
einem Kopplungselement (18), das zwischen der Abdeckplatte (10) und der Trägerplatte (16) dem Berührungsfeld (12) korrespondierend angeordnet ist und
das mit einer elektrisch leitenden Kontaktfläche (162) auf der Trägerplatte (16) in Kontakt steht, wobei
das Kopplungselement (18) einen massiven Kunststoffkörper (181) aus einem elektrisch leitfähigen und lichtdurchlässigen Material aufweist; und
wenigstens einer Lichtquelle (20) zum Einkoppeln von Lichtstrahlen in den Kunststoffkörper (181) des Kopplungselements (18).

2. Berührungs- und/oder Annäherungsschalter nach Anspruch 1,
**dadurch gekennzeichnet, dass**
der Kunststoffkörper (181) des Kopplungselements (18) eine erste Kopplungsfläche (182) aufweist, welche die dem Benutzer abgewandte Seite der Abdeckplatte (10) im Bereich des Berührungsfeldes (12) kontaktiert.

3. Berührungs- und/oder Annäherungsschalter nach Anspruch 1 oder 2,
**dadurch gekennzeichnet, dass**
der Kunststoffkörper (181) des Kopplungselements (18) eine zweite Kopplungsfläche (183) aufweist, welche die Kontaktfläche (162) der Trägerplatte (16) direkt oder über ein elektrisch leitendes Kontaktelement (185, 186, 187) elektrisch leitend kontaktiert.

4. Berührungs- und/oder Annäherungsschalter nach Anspruch 3,
**dadurch gekennzeichnet, dass**
der Kunststoffkörper (181) des Kopplungselements (18) in einem Abstand zur Trägerplatte (16) angeordnet ist; und
das Kontaktelement (186, 187) ein zwischen dem Kunststoffkörper (181) des Kopplungselements (18) und der Trägerplatte (16) angeordnetes Abstandselement ist.

5. Berührungs- und/oder Annäherungsschalter nach Anspruch 3 oder 4,
**dadurch gekennzeichnet, dass**
das Kontaktelement (185, 187) ein zwischen dem Kunststoffkörper (181) des Kopplungselements (18) und der Trägerplatte (16) angeordnetes elastisches Element ist, das den Kunststoffkörper (181) in Richtung zur Abdeckplatte (10) drückt.

6. Berührungs- und/oder Annäherungsschalter nach Anspruch 1 oder 2,
**dadurch gekennzeichnet, dass**
der Kunststoffkörper (181) des Kopplungselements (18) eine zweite Kopplungsfläche (183) aufweist, welche mit der Kontaktfläche (20) der Trägerplatte (16) kapazitiv gekoppelt ist.

7. Berührungs- und/oder Annäherungsschalter nach einem der vorherigen Ansprüche,
**dadurch gekennzeichnet, dass**
der Kunststoffkörper (181) des Kopplungselements (18) aus einem elastischen Material gemacht ist.

8. Berührungs- und/oder Annäherungsschalter nach einem der vorherigen Ansprüche,
**dadurch gekennzeichnet, dass**
die wenigstens eine Lichtquelle (20) auf und/oder in der Trägerplatte (16) montiert ist.

9. Berührungs- und/oder Annäherungsschalter nach einem der vorherigen Ansprüche,
**dadurch gekennzeichnet, dass**
das Kopplungselement (18) an der Abdeckplatte (10) und/oder an der Trägerplatte (16) befestigt ist.

10. Berührungs- und/oder Annäherungsschalter nach einem der vorherigen Ansprüche,
**dadurch gekennzeichnet, dass**
die Kontaktfläche (20) der Trägerplatte (16) relativ zum Berührungsfeld (12) der Abdeckplatte (10) versetzt angeordnet ist und das Kopplungselement (18) derart ausgestaltet ist, dass es diesen Versatz überbrückt.

## Claims

1. Capacitive touch and/or proximity switch, comprising
a covering plate (10) which defines a touch area (12) on a side which faces the user and, at least in the region of the touch area (12), is designed to be electrically insulating and at least partially transparent;
a support plate (16) which is arranged on a side of the covering plate (10) which is averted from the user and is arranged at a distance from the said covering plate; a coupling element (18) which is arranged between the covering plate (10) and the support plate (16) such that it corresponds to the touch area (12) and which is in contact with an electrically conductive contact face (162) on the support plate (16), wherein
the coupling element (18) has a solid plastic body (181) which is composed of an electrically conductive and transparent material; and
at least one light source (20) for coupling light beams into the plastic body (181) of the coupling element (18).

2. Touch and/or proximity switch according to Claim 1,
**characterized in that**
the plastic body (181) of the coupling element (18) has a first coupling face (182) which makes contact with that side of the covering plate (10) which is averted from the user in the region of the touch area (12).

3. Touch and/or proximity switch according to Claim 1 or 2,
**characterized in that**
the plastic body (181) of the coupling element (18) has a second coupling face (183) which makes electrically conductive contact with the contact face (162) of the support plate (16) directly or by means of an electrically conductive contact element (185, 186, 187).

4. Touch and/or proximity switch according to Claim 3,
**characterized in that**
the plastic body (181) of the coupling element (18) is arranged at a distance from the support plate (16); and the contact element (186, 187) is a spacer element which is arranged between the plastic body (181) of the coupling element (18) and the support plate (16).

5. Touch and/or proximity switch according to Claim 3 or 4,
**characterized in that**
the contact element (185, 187) is an elastic element which is arranged between the plastic body (181) of the coupling element (18) and the support plate (16), and which pushes the plastic body (181) in the direction of the covering plate (10).

6. Touch and/or proximity switch according to Claim 1 or 2,
**characterized in that**
the plastic body (181) of the coupling element (18) has a second coupling face (183) which is capacitively coupled to the contact face (20) of the support plate (16).

7. Touch and/or proximity switch according to one of the preceding claims,
**characterized in that**
the plastic body (181) of the coupling element (18) is made from an elastic material.

8. Touch and/or proximity switch according to one of the preceding claims,
**characterized in that**
the at least one light source (20) is mounted on and/or in the support plate (16).

9. Touch and/or proximity switch according to one of the preceding claims,
**characterized in that**
the coupling element (18) is fastened to the covering plate (10) and/or to the support plate (16).

10. Touch and/or proximity switch according to one of the preceding claims,
**characterized in that**
the contact face (20) of the support plate (16) is arranged in a manner offset in relation to the touch area (12) of the covering plate (10), and the coupling element (18) is configured such that it bridges this offset.

## Revendications

1. Commutateur tactile et/ou de proximité, comportant une plaque de recouvrement (10) qui définit un champ tactile (12) sur une face tournée vers l'utilisateur et est réalisée, au moins dans une zone du champ tactile (12), de manière à être électriquement isolante et à être au moins partiellement transparente à la lumière ;
une plaque de support (16), qui est disposée sur une face de la plaque de recouvrement (10) qui est tournée à l'opposé de l'utilisateur, de manière espacée de celui-ci ;
un élément de couplage (18) qui est disposé entre la plaque de recouvrement (10) et la plaque de support (16) d'une manière qui correspond au champ tactile (12) et qui est en contact avec une surface de contact électriquement conductrice (162) sur la plaque de support (16), dans lequel
l'élément de couplage (18) comporte un corps en matière plastique massif (181) constitué d'un matériau électriquement conducteur et transparent à la lumière ; et
au moins une source lumineuse (20) destinée à l'injection de faisceaux lumineux dans le corps en matière plastique (181) de l'élément de couplage (18).

2. Commutateur tactile et/ou de proximité selon la revendication 1,
**caractérisé en ce que** le corps en matière plastique (181) de l'élément de couplage (18) comporte une première surface de couplage (182) qui est en contact avec la face de la plaque de recouvrement (10) qui est tournée à l'opposé de l'utilisateur, dans la région du champ tactile (12).

3. Commutateur tactile et/ou de proximité selon la revendication 1 ou 2,
**caractérisé en ce que** le corps en matière plastique (181) de l'élément de couplage (18) présente une seconde surface de couplage (183) qui est en contact électrique avec la surface de contact (162) de la plaque de support (16) directement ou par l'intermédiaire d'un élément de contact électriquement conducteur (185, 186, 187).

4. Commutateur tactile et/ou de proximité selon la revendication 3,
**caractérisé en ce que** le corps en matière plastique (181) de l'élément de couplage (18) est disposé à une certaine distance de la plaque de support (16) ; et
**en ce que** l'élément de contact (186, 187) est un élément d'espacement disposé entre le corps en matière plastique (181) de l'élément de couplage (18) et la plaque de support (16).

5. Commutateur tactile et/ou de proximité selon la revendication 3 ou 4,
**caractérisé en ce que** l'élément de contact (185, 187) est un élément élastique disposé entre le corps en matière plastique (181) de l'élément de couplage (18) et la plaque de support (16), qui comprime le corps en matière plastique (181) dans la direction de la plaque de recouvrement (10).

6. Commutateur tactile et/ou de proximité selon la revendication 1 ou 2,
**caractérisé en ce que** le corps en matière plastique (181) de l'élément de couplage (18) comporte une seconde surface de couplage qui est couplée de manière capacitive à la surface de contact (20) de la plaque de support (16).

7. Commutateur tactile et/ou de proximité selon l'une quelconque des revendications précédentes,
**caractérisé en ce que** le corps en matière plastique (181) de l'élément de couplage (18) est constitué d'un matériau élastique.

8. Commutateur tactile et/ou de proximité selon l'une quelconque des revendications précédentes,
**caractérisé en ce que** l'au moins une source lumineuse (20) est montée sur et/ou dans la plaque de support (16).

9. Commutateur tactile et/ou de proximité selon l'une quelconque des revendications précédentes,
**caractérisé en ce que** l'élément de couplage (18) est fixé à la plaque de recouvrement (10) et/ou à la plaque de support (16).

10. Commutateur tactile et/ou de proximité selon l'une quelconque des revendications précédentes,
**caractérisé en ce que** la surface de contact (20) de la plaque de support (16) est disposée de manière décalée par rapport au champ tactile (12) de la plaque de recouvrement (10) et **en ce que** l'élément de couplage (18) est conçu de manière à combler ce décalage.
